# EUROPEAN PATENT APPLICATION

(11) **EP 4 679 482 A1**
(43) Date of publication of application: **14.01.2026**
(21) Application number: 24188250.5
(22) Date of filing: 12.07.2024
(51) Int. Cl.: H01J 37/20

(54) **MODULE, APPARATUS, AND METHOD OF USING THE MODULE**

(71) Applicant: ASML Netherlands B.V., 5500 AH Veldhoven (NL)
(72) Inventor: LIU, Yu, San Jose (US); SHI, Xinyue, San Jose (US); LI, Yinglong, San Jose (US)
(74) Representative: ASML Netherlands B.V.

(57) **Abstract**

The present invention provides a module for measuring clamping status of a sample on a sample support. The module comprises a pin arranged such that, when a sample is placed on the sample support, the pin is displaced by contact with a local region of the sample adjacent to the pin. The module further comprises a sensor configured to determine a distance between the local region of the sample and the sample support based on movement of the pin.

## Description

### FIELD

The embodiments provided herein generally relate to a module, an apparatus comprising the module, and a method of using the module.

### BACKGROUND

When manufacturing semiconductor integrated circuit (IC) chips, undesired pattern defects, as a consequence of, for example, optical effects and incidental particles, inevitably occur on a substrate (i.e. wafer or sample) or a mask during the fabrication processes, thereby reducing the yield. Monitoring the extent of the undesired pattern defects is therefore an important process in the manufacture of IC chips. More generally, the assessment, e.g., inspection and/or measurement, of a surface of a substrate, or other object/material, is an important process during and/or after its manufacture.

Pattern assessment systems with a charged particle beam have been used to inspect objects, for example to detect pattern defects and to measure structural features on such objects. These tools typically use electron microscopy techniques, using electron optical systems for example in a scanning electron microscope (SEM). In exemplary electron optical system such a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over, or across, the sample surface, secondary electrons can be emitted across the surface of the sample. By collecting these emitted secondary electrons from the sample surface, a pattern assessment system (or assessment tool) may obtain an image representing characteristics of the material structure of the surface of the sample. The intensity of the electron beams comprising the backscattered electrons and the secondary electrons may vary based on the properties of the internal and external structures of the sample, and thereby may indicate whether the sample has defects.

The sample may be held in place during processes, such as manufacture and inspection, by a sample support. The sample support typically comprises a clamp to secure the sample to the sample support. In some cases, the clamp is an electrostatic clamp. With this arrangement, a capacitive proximity sensor may be used to determine whether the sample is secured by the electrostatic clamp. The capacitive proximity sensor returns a voltage reflecting capacitance between the sample and clamping electrodes of the electrostatic clamp. Because the capacitance is inversely proportional to the distance between the sample and the clamping electrodes, the capacitive proximity sensor voltage depends on the averaged distance between the sample and the clamping electrodes. The capacitive proximity sensor can therefore provide an indication of the average distance between the sample and the electrodes of the electrostatic clamp.

However, in some circumstances, the clamping may be performed by a different method other than electrostatic clamping and/or the sample may not be evenly secured to the sample support across an entirety of the sample. For example, the sample may be warped such that in some local regions (e.g., peripheral regions of a sample warped into a bowl shape) of the sample a distance between the sample and the sample support is greater than in other regions of the sample (e.g., a central region of a sample warped into a bowl shape). In such circumstances, the capacitive proximity sensor is incapable of providing information about local deviations from the average distance between the sample and the sample support. There is therefore a problem of how to determine that the sample is sufficiently secured to the sample support across an entirety of the sample.

In the circumstances where a sample is not secured evenly across the sample, the processing of the sample may be compromised. For example, in an assessment of the sample on an assessment apparatus may be compromised by a sample which is not evenly secured. It is common for the space between a nearest component of the assessment apparatus and an upper surface of the sample to be very small, for example approximately 50 µm. With such a small clearance gap, a sample which is not tightly secured to the sample support may not fit within the clearance gap. Furthermore, even if the sample fits, if it is not tightly secured to the sample support, the assessment apparatus inspection beam might be out of focus with the sample. If the inspection beam is not properly focused, the assessment of the sample may be compromised.

Similarly, if the sample is not secured evenly and tightly on a sample support of a lithographic apparatus, a pattern formed on the surface of the sample may be more likely to contain errors or defects. Furthermore, lithography apparatus can comprise an actuated sample support/stage which may be configured to move with high speed and/or acceleration. In a scenario such as this if the sample is not sufficiently secured to the sample support, the sample may become loose or even be completely dislodged from the sample support. This could result in damage to the sample and/or apparatus. If the apparatus is damaged, there may be a significant amount of down time while the damaged components are repaired or replaced.

In some types of etch apparatus, the sample is submerged in liquid during etching. The liquid can have a corrosive effect. If the sample is not properly secured to the sample support, leaks may enable the liquid to contact components which are not intended to be contacted by the liquid. For example, some components of the sample support, such as burls, and/or the clamp may be detrimentally affected by exposure to the corrosive liquid.

It is therefore desirable to provide a means to more accurately determine whether the sample is secured to the sample support. This would enable a user to adjust the clamping as required to ensure the sample is sufficiently clamped to undergo the associated processing (e.g., lithography or assessment).

There is therefore a desire to provide a more effective means to determine whether and to what extent the sample is secured to the sample support.

### SUMMARY

It is an object of the present disclosure to provide embodiments of a module for measuring clamping status of a sample on a sample support, a apparatus comprising the module, and a method of using the module.

According to an aspect of the invention, there is provided a module comprises a pin arranged such that, when a sample is placed on the sample support, the pin is displaced by contact with a local region of the sample adjacent to the pin. The module further comprises a sensor configured to determine a distance between the local region of the sample and the sample support based on movement of the pin.

According to another aspect of the invention, there is provided an assessment apparatus. The assessment apparatus comprises the module.

According to another aspect of the invention, there is provided a method of assessing a clamping status of a sample on a sample support using the module.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary electron beam assessment apparatus.
**FIG. 2** is a schematic diagram illustrating an exemplary multi-beam charged particle assessment system that is part of the exemplary electron beam assessment apparatus of **FIG.1****.**
**FIG. 3A** is a schematic diagram illustrating an electrostatic clamp for clamping a sample to a sample support.
**FIG. 3B** is a schematic diagram illustrating the electrostatic clamp of FIG. 3A, with a sample disposed thereon.
**FIG. 4** is a schematic diagram illustrating a module for measuring clamping status of a sample on a sample support.

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus semiconductor IC manufacturing is a complex and time-consuming process, with many individual steps. An error in one of these steps has the potential to significantly influence the functioning of the final product. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer or sample) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by assessment systems (such as, or such as comprising, a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. Such an assessment apparatus may utilize a single primary electron beam incident on a sample. For high throughput inspection, some of the assessment apparatuses use multiple focused beams, i.e. a multi-beam, of primary electrons. The component beams of the multi-beam may be referred to as sub-beams or beamlets. The sub-beams may be arranged with respect to each other within the multi-beam in a multi-beam arrangement. A multi-beam can scan different parts of a sample simultaneously. A multi-beam assessment apparatus can therefore assess, for example inspect, a sample at a much higher speed than a single-beam assessment apparatus.

An implementation of known multi-beam assessment apparatus and systems is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons.

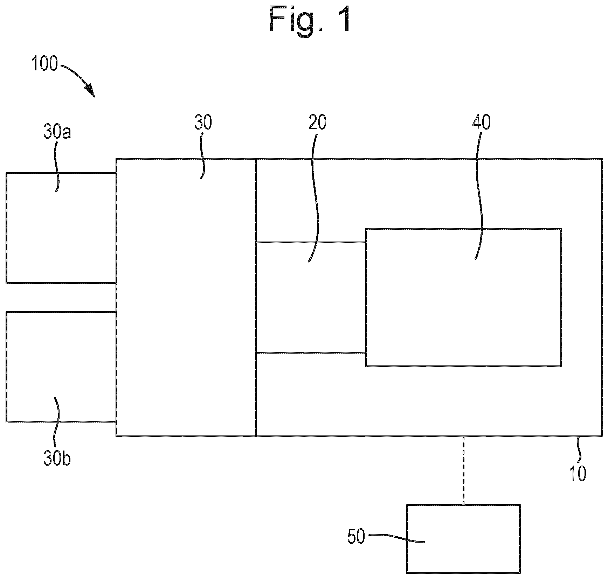

Reference is now made to **FIG. 1****,** which is a schematic diagram illustrating an exemplary charged particle beam assessment apparatus 100. It should be noted that the assessment apparatus comprises part of the assessment system, often the part of the assessment system situated in a fabrication facility. The assessment apparatus may cover a surface area of the fabrication facility floor referred to as an apparatus footprint. The other parts of the assessment system such as service systems of vacuum and fluid supplies and remote processing racks may be located elsewhere in the fabrication facility away from other fabrication systems and apparatus where space is a less significant requirement,

The charged particle beam assessment apparatus 100 of **FIG. 1** includes a main chamber 10, a load lock chamber 20, a charged particle assessment system 40 (which may also be called an electron beam system or tool), an equipment front end module (EFEM) 30 and a controller 50. The charged particle assessment system 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be assessed e.g. measured or inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the charged particle assessment system 40 by which it may be assessed.

The controller 50 is electronically connected to the charged particle assessment system 40. The controller 50 may be a processor (such as a computer) configured to control the charged particle beam assessment apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus or it can be distributed over at least two of the component elements. While the present disclosure provides examples of the main chamber 10 housing an electron beam assessment apparatus, it should be noted that aspects of the disclosure in their broadest sense are not limited to a chamber housing an electron beam assessment apparatus. Rather, it is appreciated that the foregoing principles may also be applied to other tools and other arrangements of apparatus, that operate under the second pressure.

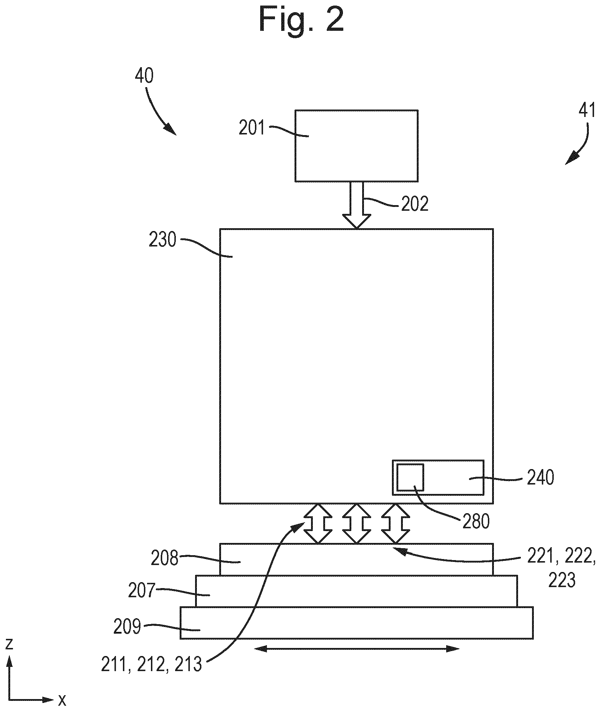

Reference is now made to **FIG. 2****,** which is a schematic diagram illustrating an exemplary charged particle assessment system 40 including a multi-beam charged particle device 41 that is part of the exemplary charged particle beam assessment apparatus 100 of **FIG. 1****.** The charged particle device 41 may be an electron-optical device, which may be synonymous with the electron-optical system. The charged particle device 41 may be a multi-beam charged particle device 41 configured to project a multi-beam towards the sample, for example the sub-beams being arranged with respect to each other in a multi-beam arrangement. Alternatively, the charged particle device 41 may be a single beam charged particle device 41 configured to project a single beam towards the sample.

The multi-beam charged particle device 41 of **FIG. 2** comprises an electron source 201 and a projection apparatus 230. The charged particle assessment system 40 further comprises an actuated stage 209 and a sample support 207. The sample support may have a holding surface (not depicted) for supporting and holding the sample. Thus the sample support may be configured to support the sample. Such a holding surface may be a electrostatic clamp operable to hold the sample during operation of the charged particle device 41 e.g. assessment such as measurement or inspection of at least part of the sample. The holding surface may be recessed into sample support, for example a surface of the sample support orientated to face the charged particle device 41. The electron source 201 and projection apparatus 230 may together be referred to as the charged particle device 41. The sample support 207 is supported by actuated stage 209 so as to hold a sample 208 (e.g., a substrate or a mask) for assessment. The multi-beam charged particle device 41 further comprises a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the charged particle beam assessment apparatus 100 of **FIG.1**, such as the electron source 201, the detector 240, the projection apparatus 230, and the actuated stage 209. The controller 50 may perform various image and signal processing functions. The controller 50 may also generate various control signals to govern operations of the charged particle beam assessment apparatus, including the charged particle multi-beam apparatus.

The projection apparatus 230 may be configured to focus sub-beams 211, 212, and 213 onto a sample 208 for assessment and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons. The secondary electrons typically have electron energy < 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding signals which are sent to a signal processing system 280, e.g. to construct images of the corresponding scanned areas of sample 208. The detector 240 may be incorporated into the projection apparatus 230.

The signal processing system 280 may comprise a circuit (not shown) configured to process signals from the detector 240 so as to form an image. The signal processing system 280 could otherwise be referred to as an image processing system. The signal processing system may be incorporated into a component of the multi-beam charged particle assessment system 40 such as the detector 240 (as shown in **FIG. 2**). However, the signal processing system 280 may be incorporated into any components of the assessment apparatus 100 or multi-beam charged particle assessment system 40, such as, as part of the projection apparatus 230 or the controller 50. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under assessment. The reconstructed images can be used to reveal various features of the internal or external structures of the sample 208. The reconstructed images can thereby be used to reveal any defects that may exist in the sample.

The controller 50 may control the actuated stage 209 to move sample 208 during assessment, e.g. inspection, of the sample 208. The controller 50 may enable the actuated stage 209 to move the sample 208 in a direction, preferably continuously, for example at a constant speed, at least during sample assessment. The controller 50 may control movement of the actuated stage 209 so that it changes the speed of the movement of the sample 208 dependent on various parameters. For example, the controller 50 may control the stage speed (including its direction) depending on the characteristics of the assessment steps of scanning process.

Known multi-beam systems, such as the charged particle assessment system 40 and charged particle beam assessment apparatus 100 described above, are disclosed in US2020118784, US20200203116, US 2019/0259570 and US2019/0259564 which are hereby incorporated by reference.

As shown in **FIG. 2****,** in an embodiment the charged particle assessment system 40 has a single charged particle device 41 and optionally comprises a projection assembly 60. The projection assembly 60 may be a module and may be referred to as an ACC module. The projection assembly 60 is arranged to direct a light beam 62 such that the light beam 62 enters between the charged particle device 41 and the sample 208.

When the electron beam scans the sample 208, charges may be accumulated on the sample 208 due to large beam current, which may affect the quality of the image. To regulate the accumulated charges on the sample, the projection assembly 60 may be employed to illuminate the light beam 62 on the sample 208, so as to control the accumulated charges due to effects such as photoconductivity, photoelectric, or thermal effects.

The sample may be held in place during inspection by a sample support. The sample support may be a sample support 207, such as that shown in FIG. 2. The sample support 207 typically comprises a clamp to secure the sample 208 to the sample support 207.

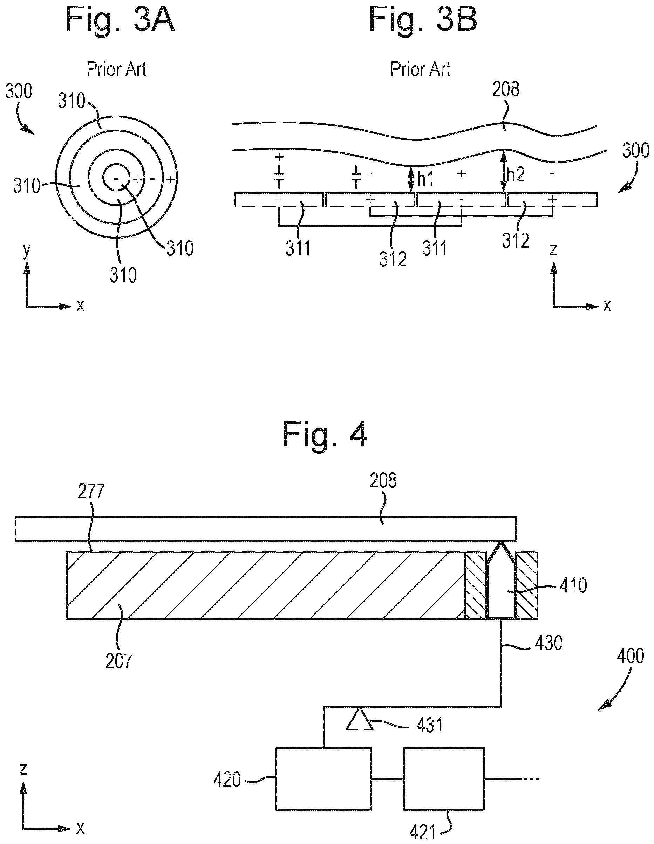

In some cases, the clamp is an electrostatic clamp. FIG. 3A and 3B illustrates an electrostatic clamp 300 comprising a plurality of clamping electrodes 310. FIG. 3A provides a plan view of the electrostatic clamp 300. FIG. 3B provides a side view of the electrostatic clamp 300 with a sample 208 clamped thereon. The clamping electrodes 310 may comprise a pair of negative clamping electrodes 311 and a pair of positive clamping electrodes 312, as shown in FIG. 3A and 3B.

With an arrangement (of the prior art) such as that of FIG. 3B, a capacitive proximity sensor may be used to determine whether the sample 208 is secured by the electrostatic clamp 300. The capacitive proximity sensor is configured to return a voltage reflecting capacitance between the sample 208 and clamping electrodes 310 of the electrostatic clamp 300. Because the capacitance is inversely proportional to the distance between the sample 208 and the clamping electrodes 310, the capacitive proximity sensor voltage depends on the averaged distance between the sample 208 and the clamping electrodes 310. The capacitive proximity sensor can therefore provide an indication of the average distance between the sample 208 and the clamping electrodes 310 of the electrostatic clamp 300.

However, in some circumstances, the clamping may be performed by a different method other than electrostatic clamping and/or the sample may not be evenly secured to the sample support across an entirety of the sample. For example, as shown in FIG. 3B the sample 208 is more tightly or closely clamped to the electrostatic clamp 300 in some regions (e.g., as shown by distance h1) than other regions (e.g., as shown by distance h2). In other words, the sample 208 may be warped such that in some local regions (e.g., peripheral regions of a sample warped into a bowl shape) of the sample 208 a distance between the sample 208 and the sample support may be greater than in other regions of the sample 208 (e.g., a central region of a sample warped into a bowl shape). In such circumstances, the capacitive proximity sensor is incapable of providing information about local deviations from the average distance between the sample 208 and the sample support. There is therefore a problem of how to determine whether the sample 208 is sufficiently secured to the sample support 207 across an entirety of the sample 208.

In the circumstances where a sample 208 is not secured evenly to the sample holder 207 across the sample 208, a pattern formed on the surface of the sample may be more likely to contain errors or defects. Similarly, if the sample 208 is not secured evenly on a sample support of an assessment apparatus 100, the assessment of the sample 208 may be compromised. It is therefore desirable to provide a means to more precisely determine whether the sample 208 is secured to the sample support 207. This would enable a user to adjust the clamping as required to ensure the sample is sufficiently clamped to undergo the associated processing (e.g., lithography or assessment).

FIG. 4 depicts a module 400 for measuring clamping status of a sample 208 on a sample support 207. The clamping status may be assessed by determining a distance between the sample 208 and the sample support 207. The module 400 comprises a pin 410. The pin 410 is arranged such that, when the sample 208 is placed on the sample support 207, the pin 410 is displaced by contact with a local region of the sample 208 adjacent to the pin 410. The module 400 further comprises a sensor 420. The sensor 420 is configured to determine a distance between the local region of the sample 208 and the sample support 207 based on movement of the pin 410.

With this approach, a distance between the sample 208 and the sample support 207 may be determined at a local region of the sample 208 corresponding to the position (in the X-Y plane of FIG. 4) of the pin 410. The distance information gathered by the sensor 420 may then be used to determine whether the sample 208 is securely clamped in the local region of the pin 410.

In the arrangement of FIG. 4, the sample support 207 optionally comprises an electrostatic clamp 300, such as that of FIG. 3. With this arrangement, a capacitive proximity sensor may also be provided in order to determine an average distance between the electrodes of the electrostatic clamp 300 and the sample 208. The global average distance measured by the capacitive proximity sensor may be considered together with the local distance measured by the sensor 420. This may provide a better overview of the clamping status than using either of the sensors in isolation. Similarly, the module 400 may be used in combination with any other means to determine the position and or/clamping status of the sample 208. For example, in addition to using the module 400, a metrology device may be disposed facing the sample 208 (on an opposite side of the sample 208 than the sample support 207) to determine the clamping status of the sample 208. The metrology device may be configured to provide global information regarding an overall position and/or shape of the sample 208.

The global information regarding the position and/or shape of the sample 208, as gathered by the capacitive proximity sensor or other metrology device, may be used together with local information based on movement of the pin 410, to estimate an overall profile of the sample 208. In other words, both global information and local information from a local region of the sample 208 may be used in order to approximately determine a shape of the sample 208. For example, it might be determined that the sample 208 is saddle or bow shaped.

The module 400 may be provided as part of an apparatus. In other words an apparatus may comprise the module 400. The apparatus may also comprise the sample support 207 configured to support the sample 208.

The module 400 may be provided in any apparatus comprising a sample support 207 configured to secure the sample 208 in place on the sample support 207. The sample support 207 may comprises a clamp configured to secure the sample 208 to the sample support 207. As described above with reference to FIG. 3 and 4, the clamp is optionally an electrostatic clamp. In alternative arrangements the clamp may, for example, use suction to secure the sample 208 to the sample support 207.

The apparatus may be an assessment apparatus 100 for inspecting the sample, such as that described above in reference to FIG. 1 and FIG. 2. The apparatus may alternatively be a lithographic apparatus for forming a pattern on the sample 208 (which is performed prior to inspection of the sample 208 on the assessment apparatus). The module 400 provides a means to determine the clamping status and therefore take action as needed if the sample 208 is not held sufficiently securely to the sample support 207. If the sample 208 is not held securely it may be misaligned and/or may be able to move relative to other components of the apparatus such that the process performed on the sample 208 is not done effectively. For example, if the sample 208 is not secured sufficiently flat to the sample support 207, the assessment apparatus may not be focused in some regions of the sample 208 and thus may not detect defects effectively in those regions. If this issue is noticed after the inspection of the sample 208, the sample 208 may have to go through a further round of inspection to ensure any defects are identified. The use of the module 400 may therefore provide a means to operate the apparatus more effectively and efficiently.

In another arrangement, the apparatus may be an etch apparatus for etching a pattern on the sample 208. In some types of etch apparatus, the sample is submerged in liquid during etching. The liquid can have a corrosive effect and therefore it is desirable that there are not leaks which may enable the liquid to contact components which are not intended to be contacted by the liquid. For example, some components of the sample support 207 and/or clamp may be detrimentally effected by exposure to the corrosive liquid. The module 400 may reduce the risk of leaks by providing information regarding a clamping status of the sample 208. If the distance information provided by the sensor indicates that the sample 208 is not securely clamped, then the clamping can be adjusted to provide effective clamping before the sample 208 is submerged in liquid. In this way, a risk of leaks due to gaps between the sample 208 and seals of the sample support 207 may be reduced. As such a risk of the liquid unintentionally coming into contact with delicate components, causing them damage which may affect performance and/or take time and cost to repair/replace, may be reduced.

The module 400 may be used to assess a clamping status of a sample 208 on the sample support 207. The sample 208 may be placed on the sample support 207 such that a local region of the sample 208 corresponds to a position of the pin 410. In other words, when the sample 208 is placed on the sample support 207, a local region of the sample 208 (e.g., a local region of an underside of the sample 208 in an X-Y plane of FIG. 4) may contact the pin 410. The sensor 420 may detect any movement of the pin 410. The movement of the pin 410 is caused by contact between the pin 410 and the local region of the sample 208. The measurement from the sensor 420 may therefore be used to determine a distance between the local region of the sample 208 and the sample support 207 based on the movement of the pin 410 as detected by the sensor 420. For example, the measurement from the sensor 420 may therefore be used to determine a distance between the local region of the sample 208 and a facing surface 277 of sample support 207 facing the sample 208 (particularly, the facing surface 277 of the sample support 207 facing an underside of the sample 208, which faces the facing surface 277 of the sample support 277).

A clamping status of the local region of the sample 208 may be determined based on the distance between the local region of the sample 208 and the sample support 207, as determined by the measurement from the sensor 420. In other words, the distance information gathered by the sensor 420 may be used to determine whether the sample 208 is securely clamped in the local region of the pin 410. For example, if the distance exceeds a predetermined threshold distance, it may be determined that the sample 208 is not sufficiently clamped in that local region. The predetermined distance may, for example, be 10 µm, preferably 5 µm, yet more preferably 3 µm, yet more preferably 2 µm, yet more preferably 1 µm. If it is determined that the sample 208 is not sufficiently clamped, an adjustment may be made, either automatically or manually by a user input, to adjust the clamping settings. For example, with an electrostatic clamp the clamping voltage may be adjusted in order to increase a clamping force on the sample 208 if it is determined that the sample 208 is not sufficiently secured to the sample support 207.

The module 400 desirably comprises a plurality of pins 410. There may be one sensor configured to measure movement of a plurality of pins 40, or each pin 410 may be associated with a corresponding, dedicated sensor 240. The plurality of pins 410 are desirably disposed to contact different local regions of the sample 208. In this way, the distance information can be gathered for a plurality of different local regions of the sample 208, such that an overall topography of the sample 208 may be approximately determined. For example, it may be determined from sensor 420 data that the sample 208 is at a greater distance from the sample support 207 in some local regions than in other local regions. Furthermore, in some arrangements, other measurement methods, for example using a capacitive proximity sensor, may also be employed to provide further distance information. The profile of the sample may then be determined based on both the distance information provided by the sensors 240 of the module 400 as well as any other appropriate sensor or metrology device. In this way, an appropriate clamping force or settings of the clamping device may be determined for samples 208 having different profiles, for example those that are bowl-shaped due to warpage.

The determined distance between the local regions of the sample 208 and the sample support 207, based on movement of the plurality of pins 410, may optionally be used to determine a profile of the sample 208. In other words, the distance information gathered by the one or more sensors 240 may be used to determine a topography of the sample 207, or at least a topography of a surface of the sample 208 (e.g., underside of the sample 208) facing the pins 410. In particular, a distance between the sample 208 and the sample support 207 may be determined at each local region having a corresponding pin 410. This distance information at multiple different local regions on the sample 208 may be used to estimate the global shape of the sample 208. For example, the sample 208 may be a convex or concave bowl shape, or may be saddle-shaped. As explained above, global information regarding the position and/or shape of the sample 208, as gathered by a capacitive proximity sensor or other metrology device, may be optionally be used together with local information based on movement of the pin 410, to estimate an overall profile of the sample 208. In other words, local information from a plurality of local regions of the sample 208 may optionally be used in combination with global information of the position of the sample in order to approximately determine a shape of the sample 208.

In the arrangement of FIG. 4, the pin 410 is arranged such that, in a condition with no sample 208 present (not shown), a tip of the pin 410 protrudes beyond the substrate support 207. In particular, the tip of the pin 410 protrudes beyond the facing surface 277 of the substrate support 207. In this way, the tip of the pin 410 is exposed such that, when a sample 208 is placed on the sample support 207, the sample 208 can contact the tip of the pin 410.

The module may further comprise a spring, or similar mechanism, configured to bias the pin 410 in a direction (Z direction of FIG. 4) towards the sample 208. The spring, or similar mechanism, is preferably configured such that the weight of the sample 208 on the pin 410 is sufficient to overcome the bias force. In this way, the pin 410 can move (e.g., downwards, in a negative Z direction of FIG. 4) due to contact with the sample 208. The movement of the pin 410 can therefore be used to determine the position of the sample 208 with respect to the substrate support 207.

The pin 410 may optionally be a grounding pin. The grounding pin may be configured to electrically ground the sample 208 when the sample 208 is on the sample support 207. In this way, the module 400 may make efficient use of existing components, with the grounding pin serving a dual purpose of grounding and aiding in assessment of clamping status.

The sensor 420 may comprise any suitable type of sensor to measure information related to the movement of the pin 410. The sensor 420 may optionally comprise a plurality of different types of sensor, such that the plurality of measured information may be used to determine a clamping status of the sample 208. The sensor 420 preferably comprises a displacement sensor configured to measure a displacement of the pin 410. In this way, the displacement of the pin 410 may be used to estimate the position of the local region of the sample 208 at the point of contact with the pin 410. Alternatively, or additionally, the sensor 420 may comprise a force sensor configured to measure a load on the pin 410. In this way, the load on the pin 410 may be used to estimate the load applied to the pin 410 by the sample 208. This load information may be used to estimate the position of the local region of the sample 208 at the point of contact with the pin 410. Alternatively, or additionally, the sensor 420 may comprise an acceleration sensor configured to measure acceleration of the pin 410. This acceleration information may be used to estimate the position of the local region of the sample 208 at the point of contact with the pin 410.

In one arrangement (not shown in the figures), the sensor 420 may be provided in direct contact with the pin 410 in order to sense movement of the pin 410. In another arrangement, ss shown, for example, in FIG. 4, the module 400 further comprises a transmission line 430 between the pin 410 and the sensor 420. The transmission line 430 is configured to transmit movement of the pin 410 to the sensor 420. In a preferred arrangement, the transmission line 430 is a mechanical transmission line. In an alternative arrangement, the transmission line 430 may be configured to transmit a signal related to movement of the pin 410.

The transmission line 430 is preferably configured to amplify the movement. In other words, the transmission line 430 may be configured such that an amplitude of movement received by the sensor 420 is greater than an amplitude of movement of the pin 410. In this way, the module 400 may enable the sensor 420 to detect small movements of the pin 410.

As shown in FIG. 4, in some arrangements, an amplifier 431 may optionally be provided in the transmission line 430 to amplify the movement of the pin 410 to the sensor 420. The amplifier 431 may be provided instead of, or in addition to, the transmission line 430 itself having an amplifying function. The amplifier 431 is intended to increase the amplitude such that a small movement of the pin 410 may be readily detected by the sensor 420.

In the arrangement of FIG. 4, the module further comprises an analogue-to-digital converter 421. The analogue-to-digital converter 421 is configured to convert the measurement from the sensor 420 from an analogue signal to a digital signal. The digital signal may then be more efficiently transmitted and processed in order to determine a clamping status of the sample 208. This may improve speed and efficiency of analysis of the measured data from the sensor 420.

As shown, for example, in FIG. 4, in some arrangements the pin 410 may be positioned such that the local region of the sample 208, which the pin 410 is configured to contact, is closer to a periphery of the sample 208 than a center of the sample 208 (in an X-Y plane of FIG. 4). The pin 410 may desirably disposed within an outer circumferential area corresponding to the outermost 40% of the radius of the sample 208, desirably an outermost 30%, yet more desirably an outermost 20% of the radius of the sample 208. The pin 410 being positioned towards a periphery of the sample 208 may be useful to determine whether the sample 208 is securely clamped in a scenario where the sample 208 is warped, e.g., in a concave bowl shape, such that the periphery of the sample 208 is raised with respect to the center of the sample 208. Furthermore, some clamps, such as some electrostatic clamps, can have a weaker clamping force towards the periphery of the sample 208. It is therefore useful to know whether a sample 208 is sufficiently secured to the sample support 207 at a periphery of the sample 208.

Alternatively, or additionally, the module 400 may comprise a pin 410 positioned such that the local region of the sample 208 is at a center of the sample 208. This may be useful to determine whether the sample 208 is securely clamped in a scenario where the sample 208 is warped such that the center is raised with respect to the periphery of the sample 208, e.g., a warped sample 208 having a convex bowl shape.

As mentioned above, the module 400 may optionally comprise a plurality of pins 410. Each pin 410 is desirably configured to be displaced by contact with a corresponding local region of the sample 208 adjacent that pin 410. With this arrangement, it is possible to obtain local distance information concerning the distance between the sample 208 and the sample support 207 at a plurality of different local regions of the sample 208. In this way, a more complete overview of how well different regions of the sample 208 are secured to the sample support 207 may be obtained compared to having only an average distance or only the distance at one local region corresponding to a single pin 410.

The plurality of pins 410 may be distributed evenly around the sample. In a preferred arrangement the pins may be arranged such the corresponding local regions are distributed circumferentially, optionally in even intervals, around the sample 208. In some arrangements, the plurality of pins 410 may comprise three or more pins 410. In one example, the three pins 410 may be distributed at intervals of 120° circumferentially around a position corresponding to a center of the sample 208. In another example, the plurality of pins 410 may comprise twelve pins 410, which are optionally distributed at even intervals circumferentially around a position corresponding to a center of the sample 208.

In some arrangements, the pins 410 may be are arranged in groups. For example, a group may consist of a pair of 2 pins 410, or a group may comprise 3 or more pins 410. The pins 410 within each group are arranged adjacent to each other. In other words, the pins 410 within a group are closer to each other than they are to any pin 410 of a different group. The groups may be evenly distributed circumferentially around the center of the sample 208. For example, each group may occupy a quadrant. In one such example, the plurality of pins 410 may consist of four groups and each group may comprise, or consist of, three pins 410.

Embodiments include the following numbered clauses:
1. A module for measuring clamping status of a sample on a sample support, comprising a pin arranged such that, when a sample is placed on the sample support, the pin is displaced by contact with a local region of the sample adjacent to the pin; and
   a sensor configured to determine a distance between the local region of the sample and the sample support based on movement of the pin.
2. The module according to clause 1, wherein the pin is a grounding pin.
3. The module according to either of clauses 1 and 2, further comprising a spring configured to bias the pin towards the sample.
4. The module according to any preceding clause, wherein the pin is arranged such that, in a condition with no sample present, a tip of the pin protrudes beyond the substrate support.
5. The module according to any preceding clause, wherein the sensor comprises a displacement sensor configured to measure a displacement of the pin.
6. The module according to any preceding clause, wherein the sensor comprises a force sensor configured to measure a load on the pin.
7. The module according to any preceding clause, wherein the sensor comprises an acceleration sensor configured to measure acceleration of the pin.
8. The module according to any preceding clause, further comprising a transmission line between the pin and the sensor, configured to transmit movement of the pin to the sensor.
9. The module according to clause 8, wherein the transmission line is configured to amplify the movement.
10. The module according to either of clauses 8 and 9, wherein an amplifier is provided in the transmission line to amplify the movement of the pin to the sensor.
11. The module according to any of clauses 8 to 10, wherein the transmission line is a mechanical transmission line.
12. The module according to any of any preceding clause, further comprising an analogue-to-digital converter configured to convert the measurement from the sensor to a digital signal.
13. The module according to any preceding clause, wherein the local region of the sample is closer to a periphery of the sample than a center of the sample.
14. The module according to any of clauses 1 to 12, wherein the local region of the sample is at a center of the sample.
15. The module according to any preceding clause, wherein the module comprises a plurality of pins, wherein each pin is configured to be displaced by contact with a corresponding local region of the sample adjacent that pin.
16. The module according to clause 15, wherein the pins are arranged such that the corresponding local regions are distributed circumferentially around the sample.
17. The module according to clause 16, wherein the pins are distributed at even intervals circumferentially around a position corresponding to a center of the sample.
18. The module according to any of clauses 15 to 17, wherein the plurality of pins comprises at least three pins.
19. The module according to clause 18, wherein the pins are distributed at intervals of 120° circumferentially around a position corresponding to a center of the sample.
20. The module according to any one of clauses 15 or 16, wherein the pins are arranged in groups, wherein the pins within a group are arranged adjacent to each other, and wherein the pins within a group are closer to each other than to any other pin.
21. An apparatus comprising a module according to any of the preceding clauses.
22. The apparatus of clause 21, comprising:
   the sample support configured to support the sample.
23. The apparatus according to either of clauses 21 and 22, wherein the sample support comprises a clamp configured to secure the second surface of the sample to the sample support.
24. The apparatus according to clause 23, wherein the clamp is an electrostatic clamp.
25. The apparatus according to any one of clauses 21 to 24, wherein the apparatus is an assessment apparatus for inspecting the sample.
26. The apparatus according to any one of clauses 21 to 24, wherein the apparatus is a lithographic apparatus for forming a pattern on the sample.
27. The apparatus according to any one of clauses 21 to 24, wherein the apparatus is an etch apparatus for etching a pattern on the sample.
28. A method of assessing a clamping status of a sample on a sample support using the module of any one of clauses 1 to 20.
29. The method of clause 28, comprising
   placing the sample on the sample support such that a local region of the sample corresponds to a position of the pin;
   detecting with the sensor any movement of the pin; and
   determining a distance between the local region of the sample and the sample support based on the movement of the pin as detected by the sensor.
30. The method of clause 29, further comprising determining a clamping status of the local region of the sample based on the determined distance between the local region of the sample and the sample support.
31. The method of either of clauses 29 and 30, further comprising adjusting the clamping force on the sample based on the determined distance between the local region of the sample and the sample support.
32. The method of any of clauses 29 to 31, further comprising using the determined distance between the local region of the sample and the sample support to determine a profile of the sample.

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies and or current supplies) to control the component to manipulate the charged particle beam in this manner. An actuatable component, such as a stage, may be controllable to actuate and thus move relative to other components such as the beam path using one or more controllers, control systems, or control units to control the actuation of the component.

References to upper and lower, up and down, above and below should be understood as referring to directions parallel to the (typically but not always vertical) upbeam and downbeam directions of the electron beam or multi-beam impinging on the sample 208. Thus, references to upbeam and downbeam are intended to refer to directions in respect of the beam path independently of any present gravitational field. These references are intended to correspond with the general direction of the electron beam from source to sample. However these references with respect to the beam path may correspond to references with respect to the electron-optical axis of device 41. For a multi-device 41, the direction of the beam path least one sub-device may correspond to the electron-optical axis of the same sub-device 41. The other sub-devices of the multi-device 41 may be calibrated with respect to the reference sub-device. The electron-optical axis may correspond to a geometrical axis of the reference sub-device and, in an embodiment, of the multi-device,

An assessment system according to an embodiment of the disclosure may be a tool which makes a qualitative assessment of a sample (e.g. pass/fail), one which makes a quantitative measurement (e.g. the size of a feature) of a sample or one which generates an image of map of a sample. Examples of assessment systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron-optical device 41 may be a component of a charged particle assessment system 40; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

The terms "sub-beam" and "beamlet" are used interchangeably herein and are both understood to encompass any radiation beam derived from a parent radiation beam by dividing or splitting the parent radiation beam. The term "beam" may be used synonymously with "sub-beam" and "beamlet". The term "manipulator" is used to encompass any element which affects the path of a sub-beam or beamlet, such as a lens or deflector.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. A module for measuring clamping status of a sample on a sample support, comprising a pin arranged such that, when a sample is placed on the sample support, the pin is displaced by contact with a local region of the sample adjacent to the pin; and
a sensor configured to determine a distance between the local region of the sample and the sample support based on movement of the pin.

2. The module according to claim 1, wherein the sensor comprises a displacement sensor configured to measure a displacement of the pin.

3. The module according to either of claims 1 and 2, wherein the sensor comprises a force sensor configured to measure a load on the pin.

4. The module according to any preceding claim, further comprising a transmission line between the pin and the sensor, configured to transmit movement of the pin to the sensor.

5. The module according to claim 4, wherein an amplifier is provided in the transmission line to amplify the movement of the pin to the sensor.

6. The module according to any preceding claim, wherein the module comprises a plurality of pins, wherein each pin is configured to be displaced by contact with a corresponding local region of the sample adjacent that pin.

7. The module according to claim 6, wherein the pins are arranged such that the corresponding local regions are distributed circumferentially around the sample.

8. An apparatus comprising a module according to any of the preceding claims.

9. The apparatus of claim 8, comprising:
the sample support configured to support the sample.

10. The apparatus according to either of claims 8 and 9, wherein the sample support comprises a clamp configured to secure the second surface of the sample to the sample support.

11. The apparatus according to any one of claims 8 to 10, wherein the apparatus is an assessment apparatus for inspecting the sample, or a lithographic apparatus for forming a pattern on the sample, or an etch apparatus for etching a pattern on the sample.

12. A method of assessing a clamping status of a sample on a sample support using the module of any one of claims 1 to 7.

13. The method of claim 12, comprising
placing the sample on the sample support such that a local region of the sample corresponds to a position of the pin;
detecting with the sensor any movement of the pin; and
determining a distance between the local region of the sample and the sample support based on the movement of the pin as detected by the sensor.

14. The method of claim 13, further comprising determining a clamping status of the local region of the sample based on the determined distance between the local region of the sample and the sample support.

15. The method of either of claims 13 and 14, further comprising adjusting the clamping force on the sample based on the determined distance between the local region of the sample and the sample support.
